# EUROPÄISCHE PATENTSCHRIFT

(11) **EP 1 156 340 B1**
(45) Veröffentlichungstag und Bekanntmachung des Hinweises auf die Patenterteilung: **20.09.2006**
(21) Anmeldenummer: 01111645.6
(22) Anmeldetag: 14.05.2001
(51) Int. Cl.: G01R 29/08, G01R 31/00

(54) **Tragbare Miniatur-EMV-Kammer für den Einsatz im Mobilfunkbereich**
Portable miniature EMC chamber for use in the field of mobile radios
Chambre CEM miniaturisée et portative pour l'utilisation dans le domaine de radios mobiles

(30) Priorität: 15.05.2000 DE 10023595
(43) Veröffentlichungstag der Anmeldung: 21.11.2001
(73) Patentinhaber: T-Mobile Deutschland GmbH, 53227 Bonn (DE)
(72) Erfinder: Burggraf, Reiner, 53844 Troisdorf (DE); Kreuz, Wolfgang, 53123 Bonn (DE)
(74) Vertreter: Riebling, Peter

(56) Entgegenhaltungen:
- WO-A-88/10026
- DE-A- 19 912 232
- US-A- 5 920 064
- US-A- 6 088 582
- PATENT ABSTRACTS OF JAPAN vol. 1998, no. 10, 31. August 1998 (1998-08-31) -& JP 10 142276 A (ANDO ELECTRIC CO LTD), 29. Mai 1998 (1998-05-29)
- PATENT ABSTRACTS OF JAPAN vol. 2000, no. 07, 29. September 2000 (2000-09-29) -& JP 2000 114765 A (SONY CORP), 21. April 2000 (2000-04-21)

## Beschreibung

Die vorliegende Erfindung bezieht sich auf eine tragbare Miniatur-EMV-Kammer für den Einsatz im Mobilfunkbereich nach dem Oberbegriff des Patentanspruchs 1.

Zur vorliegenden Erfindung sind bisher nachfolgende Vorrichtungen aus dem Stand der Technik bekannt.

Seitens der Messtechnikhersteller werden handelsüblich für die Verwendung im Mobilfunkbereich HF-Abschirmkammern, sog. Schirmkoffer, angeboten (z.B. universelle HF-Abschirmkammer mit Funkgeräteantennenkoppler CTD-Z10 der Fa. Rohde & Schwarz). Diese stellen einen miniaturisierten Faraday'schen Käfig dar, in den ein zu testendes Mobilfunk-Endgerät eingebracht werden kann, um für die daran vorzunehmenden Messungen die Einwirkungen von verfälschenden Fremdeinstrahlungen fernzuhalten.

Die bekannten Schirmkofferbeispielsweise offenbart in der JP 10 142 276 A oder der DE 199 12 232 A1 sind in der Art ausgeführt, dass ein aus Metall bestehender oder mit Metall ausgekleideter, tragbarer Koffer, der im geschlossenen Zustand den Faraday'schen Käfig bildet, mit einer HF-Durchführung versehen ist, mittels der der Antennenanschluss des in diesen Schirmkoffer einzubringenden Mobilfunk-Endgerätes aus der Schirmkammer herausgeführt wird.

Optional können herstellerseitig geeignete Antennenkoppler innerhalb des Schirmkoffers vorgesehen sein, die eine definierte Ankopplung von Mobilfunk-Endgeräten, die nur eine Einbauantenne, jedoch keinen separaten Antennenanschluss (Steckverbinder) besitzen, an den Hf-Anschluss des Schirmkoffers ermöglichen.

Weiterhin sind Lösungen bekannt, bei denen der Schirmkoffer noch zusätzlich Durchführungen für Betriebsspannung und/oder weitere externe Schnittstellen der Mobilfunk-Endgeräte besitzt.

Nachteil der bekannten Lösungen ist:

Schirmkoffer mit nur einer HF-Durchführung (ohne weitere Durchführungen für externe Schnittstellen des Mobilfunk-Endgerätes) bieten zwar eine ausreichende Abschirmung gegen Fremdfeldeinflüsse, haben jedoch den Nachteil, dass das Mobilfunk-Endgerät ausschließlich über die eigene Batterie (Akkumulator) gespeist werden kann und eine Bedienung des Endgerätes im geschlossenen Zustand des Schirmkoffers nicht möglich ist.

Bei Schirmkoffern, die zusätzlich mit einer Durchführung für die Betriebsspannung und/oder weitere externe Schnittstellen versehen sind, ist bei den bekannten Ausführungen die Schirmwirkung aufgrund der Tatsache, dass diese Durchführungen aus HF-technischer Sicht ungeeignet sind, sehr stark vermindert. Durch die HF-mässig nicht abgeblockte Schnittstelle werden störende HF-Signale, die durch die Schirmkammer vom Endgerät abgehalten werden sollen, über die Schnittstellenleitungen, die als Antenne wirken können, wieder in die Schirmkammer eingeschleift.

Diese Schirmkammem sind deshalb für den Einsatz bei Tests, bei denen die Nutzsignale im Bereich der Eingangsempfindlichkeit der Empfänger der Mobilfunk-Endgeräte liegen, ungeeignet.

Die WO 88 / 10026 A1 offenbart ein abgeschirmtes Gehäuse für elektronische Geräte, bei dem die Durchführungen für Betriebsspannung und andere Signale gefiltert werden und damit Störeinflüsse verringert werden können.

Aufgabe der vorliegenden Erfindung ist es deshalb, eine tragbare Miniatur-EMV-Kammer für den Einsatz im Mobilfunkbereich zu beschreiben, die eine externe Bedienung und die Spannungsversorgung des Mobilfunkgeräts ermöglicht, ohne dass über diese Verbindungen störende HF-Signale in die Miniatur-EMV-Kammer eindringen können und so die Messanordnung stören.

Die Lösung der gestellten Aufgabe erfolgt durch die technische Lehre des unabhängigen Patentanspruchs 1.

Die erfindungsgemäße Lösung besteht in der Anwendung der an sich für EMV-Kammern bekannten HF-Filterung von Durchführungen für Daten- und Betriebsspannungsleitungen auf einen sog. Schirmkoffer.

Durch die Zuführung der Betriebsspannung und niederfrequenter Signal- und Datenleitungen in die eigentliche HF-Abschirmkammer über HF-Filter wird die (parasitäre) Antennenwirkung sowohl dieser Leitungen als auch der Durchführungsöffnung selbst (Schlitzantennen-Wirkung bei hohen Frequenzen) drastisch verringert. Die Datenleitungen können optional anstatt durch HF-Filter auch mittels optischer Schnittstellen HF-entkoppelt in die eigentliche HF-Abschirmkammer eingeführt werden. Es werden damit Schirmdämpfungen der transportablen HF-Abschirmkammer > 50 dB für alle Mobilfunkbänder möglich.

Die erfindungsgemäße Lösung schafft eine transportable HF-Abschirmkammer im Miniaturformat, die bei Anwendung für Mobilfunk-Endgeräte die Vorteile einer echten (stationären) EMV-Kammer bietet.

Es werden damit durch diese tragbare Miniatur-EMV-Kammer Schirmdämpfungen in einer Größenordnung für alle Mobilfunkbänder möglich, die ansonsten nur mit einer stationären EMV-Kabine oder einem Schirmkoffer erreichbar sind, der nur eine HF-Durchführung, nämlich den Antennenanschluss des Mobilfunk-Endgeräts, besitzt, und bei dem keine weiteren externen Schnittstellen vorhanden sind, wodurch eine Bedienung bzw. ein Betrieb des Mobilfunkgeräts bei geschlossener Kammer nicht möglich ist. Durch die vorliegende Erfindung ist dies nun jedoch möglich. Sie ermöglicht eine Messanordnung, bestehend aus einer Miniatur-EMV-Kammer mit den erfindungsgemäßen HF-tauglichen Anschlüssen, einem Mobilfunkgerät und den entsprechenden Anschlussleitungen für Spannungsversorgung und analogen und/oder digitalen Datenaustausch.

Damit kann für spezielle Tests, bei denen die Empfangssignale für das Mobilfunk-Endgerät im Bereich der Referenzempfindlichkeit der Empfänger liegen (z.B. bei Regelabnahmen von Basisstationen, Handover-Tests usw.) auf die Benutzung spezieller Testmobilstationen verzichtet und auf die Benutzung handelsüblicher "Tracer-Mobiles" mit externer Rechnerschnittstelle zurückgegriffen werden. Es erfolgt eine weitestgehende Abschirmung des eingebrachten Mobilfunk-Endgeräts gegenüber parasitären Einstrahlungen, auch bei Beschaltung der externen Schnittstellen (Betriebsspannung, Datenleitungen, Audioleitungen) des Mobilfunk-Endgeräts. Sie sind also für den Einsatz bei Tests, bei denen die Nutzsignale im Bereich der Eingangsempfindlichkeit der Empfänger der Mobilfunk-Endgeräte liegen, geeignet.

Die HF-Filter (Tiefpass) sollten eine Grenzfrequenz im Bereich zwischen etwa 100 kHz und 1 MHz besitzen, um einerseits die Daten (ca. 9,6 kBit/s) und AudioSignale (f<20 kHz) nur gering zu bedämpfen, und andererseits eine möglichst hohe Dämpfung der Frequenzen im Mobilfunkfrequenzbereich zu erzielen. Aus diesem Grunde sind hierbei auch Bandsperrenfilter einsetzbar, die für den Mobilfunkfrequenzbereich wirksam sind. Für digitale Datenschnittstellen bei Übertragungsraten > 50 kBit/s werden zur HF-Entkopplung sinnvoll Optokoppler eingesetzt.

Die HF-Bandbreiten von Antennenkoppler und Zweiwege-Leistungsteiler/summierer sollten so gewählt werden, dass sich für die Anordnung ein Einsatzfrequenzbereich von etwa 800 MHz bis 2500 MHz ergibt. Optional sollte hierbei ein Arbeitsfrequenzbereich zwischen etwa 400 MHz und 3 GHz angestrebt werden.

Erfindungsgemäß besteht die Anordnung aus einem metallischen oder einem mit Metall EMV-gerecht ausgekleideten Schirmkoffer, der aus zwei miniaturisierten, eine konstruktive Einheit bildenden, EMV-Kammern besteht, wobei die erste mit einer oder mehreren HF-Buchsen zur Durchführung der HF-seitigen Eingangs/Ausgangssignale des einzubringenden Mobilfunk-Endgeräts nach außen ausgestattet ist, und im Weiteren über mehrere entsprechende galvanisch leitende Durchführungen zur zweiten EMV-Kammer verfügt.

Es sind also die beiden HF- oder EMV-Kammern mittels einer Trennwand getrennt, die über entsprechende galvanisch leitende Durchführungen zwischen den beiden EMV-Kammern verfügt.

Die zweite EMV bzw. HF-Kammer des Schirmkoffers besitzt weitere galvanisch leitende Durchführungen die durch die Außenwand des Schirmkoffers geführt sind. Diese Durchführungen sind innerhalb der zweiten Kammer jeweils mittels eines HF-Filters so verbunden, dass sich von jeder äußeren Durchführung eine galvanisch leitende, HF-gefilterte Verbindung in die erste Kammer ergibt. Diese Durchführungen in den HF-Kammern müssen mindestens für die positive (oder wahlweise negative) Betriebsspannung und für eine COM1-Schnittstelle (9-polig Sub-D) vorhanden sein. Optional können auch noch weitere Schnittstellen wie z. B. Audioschnittstellen (Mikrofon, Lautsprecher) sowie optische Schnittstellen (Datenschnittstellen für > 50 kBit/s) vorhanden sein.

Für den HF-Anschluss des in die Kammer einzubringenden Mobilfunk-Endgeräts an die HF-Antennenbuchse kann optional ein Antennenkoppler vorhanden sein. Weiterhin kann optional in die Verbindung zwischen Antennenbuchse und Mobilfunk-Endgerät ein Zweiweg-Leistungsteiler/summierer angeordnet sein, der mit der HF-Buchse verbunden ist und der als Test-Eingang/Ausgang für den Anschluss zusätzlicher HF-Messgeräte (Spektrums-Analysator, Messempfänger, HF-Generator als Interferer) dienen kann.

Nachfolgend wird die vorliegende Erfindung anhand der Beschreibung einer Abbildung unter Bezugnahme auf die einzelnen Zeichnungs-Positionen näher beschrieben.

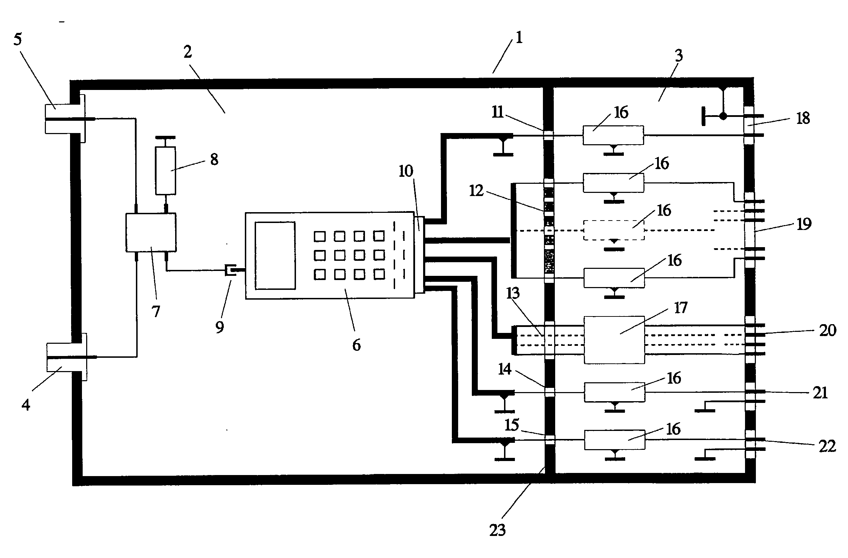

Das Bild 1 zeigt einen Schnitt durch die Anordnung, bestehend aus einer Miniatur-EMV-Kammer mit den erfindungsgemäßen HF-tauglichen Anschlüssen, einem Mobilfunkgerät und den entsprechenden Anschlussleitungen für Spannungsversorgung und analogen und/oder digitalen Datenaustausch.

Das Bild 1 zeigt die prinzipielle Ausführung der gesamten Messanordnung. Als räumliche Abgrenzung gegenüber der mit hochfrequenten Signalen belasteten Messumgebung dient die EMV-Kammer 1, welche in sich aus zwei EMV-Kammern 2 und 3 besteht. Die Kammer 2 bildet dabei die Hauptkammer, in welcher die Messanordnung mit dem Mobilfunk-Endgerät 6 untergebracht ist. In dieser Kammer 2 befinden sich in einer besonderen Ausführungform auch ein Zweiweg-Leistungsteiler/-summierer (3 dB-Hybrid) 7 mit einem entsprechenden 50 Ohm-HF-Abschluss 8 für den Leistungsteiler 7. Die Anordnung des Leistungsteilers/-summierers 7 mit dem daran angeordneten 50 Ohm-HF-Abschluß ist jedoch nicht zwingend für alle Ausführungsformen notwendig.

Im weiteren befinden sich in der Kammer die HF-Buchsen 4 und 5 sowie ein Antennenkoppler 9 und ein Anschlussstecker 10, an welche das Mobilfunk-Endgerät 6 angeschlossen wird. Der Antennenkoppler 9 kann im einfachsten Fall durch einen HF-Stecker gebildet sein. Das setzt jedoch das Vorhandensein einer entsprechenden Antennenbuchse am Mobilfunk-Endgerät voraus. Für Mobilfunk-Endgeräte mit eingebauten Antennen sind auch kapazitiv oder induktiv wirkende Antennenkoppler bekannt.

Der Anschlussstecker 10 kann in entsprechenden Ausführungsformen auch mehrteilig ausgebildet sein, je nach Anschlussmöglichkeit des Mobilfunk-Endgerätes 6. Über die HF-Buchsen 4 und 5 wird die Verbindung des Mobilfunk-Endgerätes mit der Messumgebung hergestellt. Im einfachsten Ausführungsfall wird die Verbindung zwischen HF-Buchse 4 direkt zum Antennenkoppler 9 ausgeführt.

In der dargestellten Ausführungsform mit den beiden HF-Buchsen 4 und 5, dem Zweiweg-Leistungsteiler/-summierer 7 und dem 50 Ohm-HF-Abschluss 8 ist mit der HF-Buchse 5 ein zusätzlicher Aus-/Eingang zu Testzwecken vorhanden.

Neben der Kammer 2 ist innerhalb der EMV-Kammer 1 eine Kammer 3 angeordnet, welche Mittel für die Durchführung der Versorgungsleitungen für Spannungsversorgung und analogen und/oder digitalen Datentransfer beinhaltet. Die Durchführungen 11 bis 15 dienen zur Durchführung der entsprechenden Anschlüsse zwischen der Kammer 2 und der Kammer 3.

Die Anschlussbuchsen 18 bis 22 dienen zur Einspeisung der entsprechenden Leitungen in die EMV-Kammer 1, wobei diese Leitungen zuerst in die Kammer 3 geführt werden. In dieser Kammer 3 befinden sich nun erfindungsgemäß die HF-Filter 16, welche zur Filterung der hochfrequenten Signale aus den Leitungen dienen. Diese HF-Filter sind für die HF-Filterung der Versorgungsspannungsleitungen (von Buchse 18), der Datenleitungen für niedrige Datenraten < ca. 50 kBit/s (von Buchse 19) sowie der AudioSchnittstellen (Mikrofon und Lautsprecher, Buchsen 21 und 22) vorgesehen. Optional können die Datenleitungen, insbesondere bei Datenraten > 50 kBit/s (Buchse 20) auch über einen Optokoppler 17 in die Kammer 2 eingebracht werden. Die optionale Daten-Schnittstelle (Buchse 20) kann auch als Infrarot-Schnittstelle ausgeführt sein.

Durch diese Anschlussart des Mobilfunk-Endgerätes 6 können Einkopplungen, die über Schirme oder sonstige Anschlüsse oder auch durch die Öffnungen verursacht werden, durch Ausfilterung oder Abblockung vom Mobilfunk-Endgerät 6 ferngehalten werden. Dadurch besteht nun erstmals die Möglichkeit, eine tragbare Miniatur-EMV-Kammer 1 für den Einsatz im Mobilfunkbereich herzustellen, welche eine entsprechende HF-Signal-Abschirmung gewährleistet, die bisher nur durch stationäre EMV-Kammern erzielt werden kann, oder durch Schirmkoffer, welche lediglich eine einzige Durchführung für die Antennenleitung des Mobilfunk-Endgerätes, also nur eine HF-Durchführung, aufweisen und damit eine Bedienung des eingebrachten Mobilfunk-Endgerätes zumindest stark erschweren, wenn nicht gar unmöglich machen .

Der Vorteil der vorliegenden Erfindung liegt also darin, dass sowohl die Spannungsversorgung, als auch die Audio- und Datenleitungen HF-gerecht in die tragbare Miniatur-EMV-Kammer 1 problemlos von außen zugeführt werden können, ohne dass dazu zusätzliche Maßnahmen notwendig sind, welche eine HF-Signalabschirmung erforderlich machen, um die HF-Einstrahlungen aus der Messumgebung zu verhindern. Das bedeutet also, die tragbare Miniatur-EMV-Kammer 1 kann problemlos in jeder Umgebung eingesetzt werden. Dabei kann das eingebrachte Mobilfunk-Endgerät aus einer externen DC-Stromversorgung über die Anschlußbuchsen 18 gespeist werden. Optional kann über Netzfilter der HF-gerechte Einbau eines AC-Netzteiles (230V) für die Zwecke der Stromversorgung des Mobilfunk-Endgerätes und/oder der optionalen Optokoppler in der Kammer 3 vorgesehen sein. Eine Nutzung für Sprachübertragung ist über die Audioschnittstellen 21 und 22 bei Anschluss externer Lautsprecher und Mikrofone jederzeit möglich. Die Bedienung sowie der Datenaustausch erfolgt vorzugsweise mittels der vorgesehenen Datenleitungen über den Anschluss eines geeigneten PCs an Buchse 19. Der Datenaustausch zwischen Mobilfunk-Endgerät und PC bei hohen Datenraten > 50 kBit/s erfolgt vorzugsweise über die optional vorhandene Buchse 20.

Ein weiterer Vorteil besteht darin, dass durch den Einsatz der tragbaren Miniatur-EMV-Kammer 1 der Betreiber des Mobilfunk-Endgerätes bei Tests unabhängig von den Beschränkungen der Betriebszeit des Mobilfunk-Engerätes durch die im Endgerät eingesetzten Batterien oder Akkumulatoren ist.

Der gesamte Aufbau der Miniatur-EMV-Kammer besteht also aus einer EMV-Kammer 1, welche in zwei Kammern 2 und 3 unterteilt ist. Die Unterteilung erfolgt durch die Ausbildung einer Trennwand 23, die die beiden Kammern 2 und 3 elektrisch voneinander trennt. Diese Trennwand kann im einfachsten Fall durch eine auf drei Seiten galvanisch leitend mit der Wand der Kammer 1 verbundenen Trennwand bestehen. Sie kann jedoch auch dadurch gebildet werden, dass in die Kammer 1 eine mit den entsprechenden Durchführungen versehene Kammer 3 komplett eingebracht und galvanisch verbunden wird.

In der Kammer 3 sind die HF-Filter 16 und optional auch die Optokoppler 17 angeordnet, die die HF-Signale aus der Messumgebung, welche über die Anschlussleitungen parasitär eingeschleift werden könnten, ausfiltern. Die Ein/Auskopplung der Anschlussleitungen in die Kammer 3 erfolgt über die Buchsen 18 bis 22. Nach der Ausfilterung durch die HF-Filter 16 bzw. HF-Abblockung durch die Optokoppler 17 werden die analogen und/oder digitalen Signale bzw. die Spannungsversorgung für das Mobilfunk-Endgerät über die Durchführungen 11 bis 15 in die Kammer 2 an den Anschlussstecker 10 für das Mobilfunk-Endgerät geführt. Auf diese Art ist die Stromversorgung und der Betrieb des Mobilfunk-Endgeärts in der Miniatur-EMV-Kammer sichergestellt.

Die Einspeisung/Ausgabe der Funksignale über die HF-Buchsen 4 und 5 kann wahlweise unter Zwischenschaltung des Zweiweg-Leistungsteilers/-summierers 7 erfolgen. Von diesem Zweiweg-Leistungsteiler/-summierer 7 führt eine HF-Leitung zum Antennenkoppler 9. Wird als Zweiweg-Leistungsteiler/-summierer ein 3 dB-Hybrid-Koppler benutzt, so ist der nicht benutzte Port dieses Kopplers mit einem 50 Ohm HF-Abschluss abzuschließen. Der Einsatz des Zweiweg-Leistungsteilers/-summierers 7 ist jedoch nicht zwingend erforderlich, sondern optional möglich. Wird der Zweiweg-Leistungsteiler/-summierer 7 nicht eingebaut, so ist die von Buchse 4 kommende HF-Leitung direkt mit dem Antennenkoppler 9 zu verbinden. In diesem Falle entfällt auch der Einbau von Buchse 5.

Der Einsatz des Zweiweg-Leistungsteilers/-summierers schafft einen zusätzlichen Test-Ein/Ausgang für die Miniatur-EMV-Kammer.

### Zeichnungs-Legende

- 1: EMV-Kammer
- 2: Kammer
- 3: Kammer
- 4: HF-Buchse
- 5: HF-Buchse
- 6: Mobilfunk-Endgerät
- 7: Zweiweg-Leistungsteiler/-summierer
- 8: 50 Ohm-HF-Abschlusswiderstand
- 9: Antennenkoppler
- 10: Anschlussstecker
- 11: Durchführung
- 12: Durchführung
- 13: Durchführung
- 14: Durchführung
- 15: Durchführung
- 16: HF-Filter
- 17: Optokoppler
- 18: Anschlussbuchse für Stromversorgung
- 19: Anschlussbuchse für Datenleitungen (galvanisch)
- 20: An schlussbuchse für Datenleitungen (optisch)
- 21: Audio-Anschlussbuchse
- 22: Audio-Anschlssbuchse
- 23: Trennwand

## Patentansprüche

1. Tragbare Miniatur-EMV-Kammer für den Einsatz im Mobilfunkbereich, ausgestattet mit einer oder mehreren HF-Buchsen (4, 5) für den Antennenanschluss eines Mobilfunk-Endgerätes (6), wobei eine Spannungsversorgung und Leitungen für den digitalen und analogen Datenaustausch zu einem oder mehreren externen Geräten mittels HF-Filtern (16) störungsfrei in die EMV-Kammer (1) zugeführt werden
**dadurch gekennzeichnet,**
**dass** die EMV-Kammer (1) eine erste Kammer (2) und eine von dieser durch eine Trennwand (23) abgetrennte zweite Kammer (3) aufweist, wobei die Spannungsversorgung und die Leitungen für den digitalen und analogen Datenaustausch von außen her zuerst in die zweite Kammer (3) geführt sind, dass die HF-Filter (16) in der zweiten Kammer (3) angeordnet sind, wobei eine Ein-/Auskopplung der Anschlussleitungen in die zweite Kammer (3) über Buchsen (18 bis 22) erfolgt, die an die HF-Filter (16) angeschlossen sind, und eine Ein-/Auskopplung der Leitungen von der zweiten Kammer (3) durch die Trennwand (23) in die erste Kammer (2) über HF-Durchführungen (11 bis 15) erfolgt, und
**dass** das Mobilfunk-Endgerät in der ersten Kammer (3) angeordnet und über einen Anschlussstecker (10)mit den in die erste Kammer geführten Leitungen verbunden ist.

2. EMV-Kammer nach Anspruch 1, **dadurch gekennzeichnet, dass** die in die zweite Kammer (3) geführten Leitungen für den digitalen Datenaustausch zu einem oder mehreren externen Geräten an Optokoppler (17) angeschlossen sind.

3. EMV-Kammer nach einem der Ansprüche 1 oder 2, **dadurch gekennzeichnet, dass** das Mobilfunk-Endgerät über eine Infrarot-Schnittstelle mit den Ausgängen der Optokoppler (17) verbunden ist.

4. EMV-Kammer nach einem der Ansprüche 1 bis 3, **dadurch gekennzeichnet, dass** ein Antennenkoppler (9) des Mobilfunk-Endgeräts mit den HF-Buchsen (4, 5) zum Zwecke einer Funkverbindung verbunden ist.

5. EMV-Kammer nach Anspruch 4, **dadurch gekennzeichnet, dass** zwischen Antennenkoppler (9) und HF-Buchsen (4, 5) ein Zweiweg-Leistungsteiler/summierer (7) angeordnet ist.

6. EMV-Kammer nach einem der Ansprüche 1 bis 5, **dadurch gekennzeichnet, dass** ein Netzteil für die Zwecke der Stromversorgung des Mobilfunk-Endgerätes oder anderer schaltungtechnischer Komponenten in der zweiten Kammer (3) angeordnet ist.

## Claims

1. Portable miniature electromagnetic compatibility chamber for use in the domain of mobile radio, equipped with one or more RF jacks (4, 5) for the antenna connection of a mobile radio terminal (6), a voltage supply and lines for digital and analogue data exchange to one or more external devices by means of RF filters (16) being fed into the electromagnetic compatibility chamber (1) without interference,
**characterised**
**in that** the electromagnetic compatibility chamber (1) has a first chamber (2) and a second chamber (3) separated therefrom by a dividing wall (23), the voltage supply and the lines for digital and analogue data exchange being conducted from outside first into the second chamber (3),
**in that** the RF filters (16) are arranged in the second chamber (3), coupling in or out of the connection lines into the second chamber (3) being done via jacks (18 to 22), which are connected to the RF filters (16), and coupling in or out of the lines from the second chamber (3) through the dividing wall (23) into the first chamber (2) is done via RF ducts (11 to 15) and
**in that** the mobile radio terminal is arranged in the first chamber (3) and connected to the lines conducted into the first chamber via a connection plug.

2. Electromagnetic compatibility chamber according to claim 1, **characterised in that** the lines conducted into the second chamber (3) for digital data exchange to one or more external devices are connected to optical couplers (17).

3. Electromagnetic compatibility chamber according to one of claims 1 or 2, **characterised in that** the mobile radio terminal is connected to the outputs of the optical couplers (17) via an infrared interface.

4. Electromagnetic compatibility chamber according to one of claims 1 to 3, **characterised in that** an antenna combiner (9) of the mobile radio terminal is connected to the RF jacks (4, 6) for the purpose of a radio connection.

5. Electromagnetic compatibility chamber according to claim 4, **characterised in that** a two-way power splitter/analogue adder (7) is arranged between the antenna combiner (9) and the RF jacks (4, 5).

6. Electromagnetic compatibility chamber according to one of claims 1 to 5, **characterised in that** a network part for the purposes of power supply to the mobile radio terminal or other components of circuit technology is arranged in the second chamber (3).

## Revendications

1. Chambre CEM miniature portative destinée au domaine de la téléphonie mobile, équipée d'une ou plusieurs douilles HF (4, 5) pour le raccordement de l'antenne d'un téléphone mobile (6), une alimentation en courant et des lignes pour l'échange de données numériques et analogiques avec un ou plusieurs appareils extérieurs étant amenées sans parasites dans la chambre CEM (1) à l'aide de filtres HF (16),
**caractérisée en ce que** ladite chambre CEM (1) comprend une première chambre (2) et une seconde chambre (3) séparée de celle-ci par une cloison (23), l'alimentation en courant et les lignes pour l'échange de données numériques et analogiques étant tout d'abord amenées dans la seconde chambre (3), de l'extérieur,
**en ce que** les filtres HF (16) sont disposés dans la seconde chambre (3), un couplage/découplage des lignes de raccordement dans la seconde chambre (3) se faisant par l'intermédiaire de douilles (18 à 22) qui sont reliées aux filtres HF (16), et un couplage/découplage des lignes de la seconde chambre (3) vers la première chambre (2) se faisant à travers la cloison (23) par l'intermédiaire de passages HF (11 à 15),
et **en ce que** le téléphone mobile est disposé dans la première chambre (3) et est relié grâce à une fiche de raccordement (10) aux lignes amenées dans la première chambre.

2. Chambre CEM selon la revendication 1, **caractérisée en ce que** les lignes qui arrivent dans la seconde chambre (3) pour l'échange de données numériques avec un ou plusieurs appareils extérieurs sont raccordées à des optocoupleurs (17).

3. Chambre CEM selon la revendication 1 ou 2, **caractérisée en ce que** le téléphone mobile est relié par une interface à infrarouge aux sorties des optocoupleurs (17).

4. Chambre CEM selon l'une des revendications 1 à 3, **caractérisée en ce qu'**un coupleur d'antenne (9) du téléphone mobile est relié aux douilles HF (4, 5) en vue d'une liaison radio.

5. Chambre CEM selon la revendication 4, **caractérisée en ce qu'**un diviseur/totalisateur de puissance à deux voies (7) est disposé entre le coupleur d'antenne (9) et les douilles HF (4, 5).

6. Chambre CEM selon l'une des revendications 1 à 5, **caractérisée en ce qu'**un bloc d'alimentation est disposé dans la seconde chambre (3) en vue d'alimenter en courant le téléphone mobile ou d'autres éléments techniques de commutation.
